# EUROPEAN PATENT SPECIFICATION

(11) **EP 4 090 133 B1**
(45) Date of publication and mention of the grant of the patent: **15.10.2025**
(21) Application number: 21173458.7
(22) Date of filing: 12.05.2021
(51) Int. Cl.: H05B 6/12

(54) **INDUCTION COOKING HOB HAVING TWO BOARD ELEMENTS ELECTRICALLY AND MECHANICALLY COUPLED TO EACH OTHER**
INDUKTIONSKOCHFELD MIT ZWEI ELEKTRISCH UND MECHANISCH MITEINANDER GEKOPPELTEN PLATTENELEMENTEN
TABLE DE CUISSON PAR INDUCTION COMPORTANT DEUX ÉLÉMENTS DE PLAQUE COUPLÉS ÉLECTRIQUEMENT ET MÉCANIQUEMENT L'UN À L'AUTRE

(43) Date of publication of application: 16.11.2022
(73) Proprietor: ELECTROLUX APPLIANCES AKTIEBOLAG, 105 45 Stockholm (SE)
(72) Inventor: VIROLI, Alex, 47122 Forli (IT); NOSTRO, Massimo, 47100 Forli (IT); ZANGOLI, Massimo, 47100 Forli (IT); URGESE, Emanuel, 47122 Forli (IT); SCOTTO D'APOLLONIA, Adriano, 47122 Forli (IT); SCHIARATURA, Elia, 47100 Forli (IT); MENGOZZI, Alan, 47122 Forli (IT)
(74) Representative: Electrolux Group Patents

(56) References cited:
- EP-A1- 3 267 766
- EP-A1- 3 544 374
- WO-A1-2019/135116
- DE-U1- 29 619 516

## Description

The present invention relates to an induction cooking hob.

EP 3 599 793 A1 discloses an induction hob having a printed circuit board with driving circuitry, wherein the printed circuit board is mounted in a housing so as to be exposed to an air stream generated by a fan. Components of the drive circuitry such as IGBTs that require intensive cooling are mounted in a cutout of the printed circuit board at a bottom side of a cooling body.

DE-U-29619516 discloses a cooking hob in which a first board element carrying sensor and display elements and a second board element carrying control elements are parallel towards one another. The solution as disclosed in DE-U-29619516 allows an easier mounting of the cooking hob in view of differing requests from varying clients.

The object of the present invention is to provide an induction cooking hob having a flexible design.

This object is solved by an induction cooking hob according to claim 1.

Directly mechanically coupled shall be understood in particular such that the first board element and the second board element are in direct physical contact to each other. Direct coupling of a first board element and a second board element allows to provide the first board element with a first functionality, e.g. as a power board for the induction cooking hob configured and adapted for powering the induction cooking hob. The second board element can have a second functionality being different from the first functionality, e.g. the second board element may be configured and adapted as a control board for controlling the induction cooking hob and in particular for controlling the power electronics on the power board. The subject matter of the invention enables that surface mounted device (SMD) components that were arranged on a first board element or a power board in conventional induction cooking hobs according to the state of the art, can be shifted to be arranged on the second power board or the control board. This allows to reduce the overall dimensions of the power board. Additionally, the proposed solution enables increased modularity in a sense that one type of a first board element can be used for a wide range of induction cooking hobs, wherein the one type of the first board element can be combined with a variety of types of a second board element in order to provide variable control functionality. Furthermore, shifting the surface mounted device (SMD) components to the second board element simplifies the redesign of the induction cooking hob in the case of a shortage of a specifically used type of (SMD) microcontroller used on a specific control board. In such a case, the electric/electronic design of the first board element can be maintained, wherein only the electric/electronic design of the second board element has to be redesigned by using an available type of microcontroller.

Moreover, the first board element and/or the second board element comprise(s) a substantially flat and/or substantially planar substrate element. The substrate element of the second board element is arranged non-parallel, preferably orthogonal, to the substrate element of the first board element and the substrate element of the second board element extends within, preferably passes through, at least one recess of the substrate element of the first board element.

Thus, the first and second board element can be electrically and directly mechanically coupled without using any further connecting elements. In conventional solutions of the prior art, dual-in line connectors (so-called: DIL connectors) are required for mounting specific types of through hole mounted devices on the first board element, specifically on power boards. Printed circuit boards on which DIL connectors are mounted typically require a cost intensive electroless nickel immersion gold (so-called: ENIG-finish) which is a metal plating process used in the production of printed circuit boards to avoid oxidation and in order to improve the solderability of copper contacts and plated through holes. The proposed solution allows avoidance of DIL connectors on the first board element. Consequently, an ENIG-finish is not required for the first board element according to the invention. Further, non-parallel arrangement of the second board element allows to reduce the area of the first board element.

According to an advantageous embodiment of the invention the first board element is a printed circuit board and/or in that the second board element is a printed circuit board, in particular wherein the first printed circuit board is a power board of the induction cooking hob and/or wherein the second printed circuit board is a control board of the induction cooking hob.

The positive effect of the invention is particular advantageous in a combination of a control board and a power board of an induction cooking hob. Thus, different types of induction cooking hobs can be provided with different control functionality and still may all comprise the same power board for powering the induction cooking hob. In general, a power board shall be understood as a board which comprises means for powering one or more induction elements such as induction coils of the induction cooking hob. Means for powering one or more induction coils may comprise one or more power generators of the induction cooking hob, wherein one or more power generators are associated to one induction coil in order to power the induction coil to which the one or more power generators are associated. Alternatively or additionally, such means may comprise a quasi-resonant inverter or a resonant half-bridge converter or an insulated gate bipolar transistor. A control board shall be understood as a board which comprises means for controlling operation of the induction cooking hob and specifically controlling the operation of the power board.

According to a further advantageous embodiment, the first board element comprises a paper based composite epoxy material, in particular including at least one or two layers of woven glass fabric, and the second board element comprises a glass reinforced epoxy laminate material.

In particular, the paper based composite epoxy material may be a CEM1 material which is a base material for printed circuit boards that is made of laminated paper. CEM1 has a core of paper, impregnated with epoxy and one layer of glass fabric. Due to the paper core, CEM1 is not suitable for through-plating. The glass reinforced epoxy laminate material may be a FR4 material which is a flame retardant. Since CEM1 is cheaper than FR4, the proposed solution allows cost reduction, since shifting of surface mounted device (SMD) components from the first board element to the second board element allows to provide the first board element to be made from CEM1 instead of FR4.

According to a further advantageous embodiment of the invention, the substrate element of the second board element is directly soldered to the substrate element of the first board element, in particular wherein the substrate element of the second board element is additionally attached to the substrate element of the first board element by an adhesive.

By directly soldering the first to the second board element, electrical and mechanical coupling between the board elements can be established in one step. No additional connecting elements are necessary. In a case, wherein the soldering alone does not provide sufficient structural strength, an additional adhesive may be applied.

Furthermore, it may be advantageous if the second board element, in particular the substrate element of the second board element, comprises a projecting portion which passes through the recess provided in or on, in particular in the substrate element of, the first board element.

Thus, the structural strength or firmness of the mechanical coupling between the first and the second board element can be provided by the substrate element of the board elements which have a high rigidity and firmness as such. Additionally, first and second board element mutually support each other against mechanical deformation.

Advantageously, the first board element is in direct, in particular touching, contact to the second board element, in particular wherein the second board element comprises least one or two or more cutouts that are delimited by one or two or more bearing surfaces provided for bearing on the first board element and/or that are delimited by the projecting portion of the second board element.

The second board element can be inserted into the first board element and moved through the recess until the bearing surfaces abut to the substrate element of the first board element. Thus, the second board element can be easily disposed in its intended operating position relative to the first board element.

According to a further advantageous embodiment, the recess is a slot or slit or another appropriately formed opening being arranged in the substrate element of the second board element, in particular wherein the slot or the slit has a width being substantially identical to the thickness of the substrate element of the first board element.

E.g. it is possible to provide the dimensions of the recess and the thickness of the substrate element in way that a press fit or a play fit is achieved. Thus, a high strength of the mechanical connection between first and second board element can be achieved even before the soldering connection is applied. Alternatively, it is also possible to provide the slot or slit with a width being larger than the thickness of the substrate element of the first board element. In this case, insertion of the first board element into the slot or slit may be simplified.

Additionally, the recess can have a width in a range from 0,8mm to 3,2mm, in particular in a range from 1mm to 2mm, preferably in a range from 1,4mm to 1,8mm. Additionally or alternatively, the projecting portion may protrude beyond the surface of the substrate element of the second board element in a range from 1mm to 5mm, in particular in a range from 2mm to 4mm, preferably 3mm.

These ranges have been found as providing the highest stability for the mechanical connection as well as being advantageously adapted to the soldering process, in that the solder can be sufficiently applied to the corner formed by the first and second board element in a simple way.

Further advantageously, the projecting portion comprises a plurality of conductors, wherein a part of the plurality or all of the conductors are provided for being electrically connected to respective corresponding conductors arranged on the first board element, wherein a part of the plurality or all of the conductors are provided for being fixedly assigned to the respective corresponding conductors arranged on the second board element.

The conductors of the second board element are specifically configured and adapted to be soldered to their respective counterpart conductors of the first board elements. Thus, it is possible to move the conductors of the second board element into their position fitting with their counterpart conductors on the first board element by simply moving or inserting the second board element into position within the first board element.

According to a furthermore advantageous embodiment, the form of the projecting portion and/or the position of the conductors on the projecting portion is adapted to the form of the recess and/or to the position of the respective corresponding conductors on the first board element such that the conductors on the projecting portion and the corresponding conductors on the first board element exactly fit together after insertion of the projecting portion into the recess, in particular such that the conductors can be electrically and/or mechanically connected to their fixedly assigned counterparts on the first board element, preferably by a soldering process, after insertion of the projecting portion into the recess.

Thus, connection of the first and second board element is enabled in a very simple way without the use of any additional connectors. Additionally, the electrical coupling between first and second board element, specifically between the conductors of first and second board element can be established in a very precise and simple way.

It is also advantageous to arrange the second board element in a peripheral region of the first board element adjacent to a first peripheral edge and/or adjacent to a second peripheral edge of the first board element, in particular such that a longitudinal extension of the second board element is substantially parallel to the first peripheral edge of the first board element and/or such that a longitudinal extension of the second board element is substantially orthogonal to the second peripheral edge of the first board element.

The second board element may be arranged in a corner region of the first board element. Providing the second board element close to the peripheral edges of the first board element allows to provide a compact design of the assembly of first and second board element. Further, such an arrangement allows safe manual insertion of the second board element into the first board element. The worker can insert the second board element in a peripheral region of the first board element and thus can avoid to reach into a section where electrical and/or electronical components are disposed but not yet mechanically fixed since the soldering process for fixing the electrical and/or electronical components and the second board element has not yet been carried out. Unintended manipulation of the electrical and/or electronical components can be avoided.

According to a further advantageous embodiment of the invention, at least one third board element is provided, wherein the third board element may be electrically coupled and directly mechanically coupled to the first board element in the same way as the second board element, in particular wherein the second board element and the third board element are arranged in different peripheral regions of the first board element, preferably that are opposite to each other, in particular wherein the first board element comprises circuitry in the region between second board element and the third board element and wherein the region of the first board element between the second board element and the first peripheral edge does not comprise any circuitry and/or wherein the region of the first board element between the third board element and a peripheral edge adjacent to the third board element does not comprise any circuitry.

Providing a third or a fourth or more additional board elements allows to provide additional and variable functionality on the first board element. For example, it is possible to provide control boards for each induction coil or to separate the electrical and/or electronical components of one control board and to distribute the components on two or more control boards.

According to a further advantageous embodiment, the first board element comprises exclusively through hole mounted electrical and/or electronical components,
and/or characterized in that the second board element and/or the third board element comprises exclusively surface mounted device electrical and/or electronical components.

Accordingly, it is possible to combine the first and second board elements to one common board including two different types of electric and/or electronical components, wherein costs can be reduced and the performance of the board can be improved.

Furthermore, a method for producing an induction cooking hob according to the invention is suggested, wherein the first board element comprises through hole mounted components and wherein the second board element and the through hole mounted components are soldered to the first board element in one soldering step.

Quick and efficient mounting of the electric and/or electronic components is, thus, possible. Additionally, first and second board elements comprising different substrate element materials and different types of electric and/or electronical components can be combined to one common board in order to provide a large variety of functionality.

The invention will be explained in further detail with reference to the accompanying drawings, in which:
- Fig. 1: is a top view of an induction cooking hob with removed cooking hob plate according to the invention;
- Fig. 2: is an exploded perspective view of a first board element and a second board element of an induction cooking hob;
- Fig. 3: is an assembled perspective view of the first board element and the second board element as shown in Fig. 2; and
- Fig. 4: is an enlarged view of a section of the projecting portion of the first board element as shown in Fig. 2 or Fig. 3;

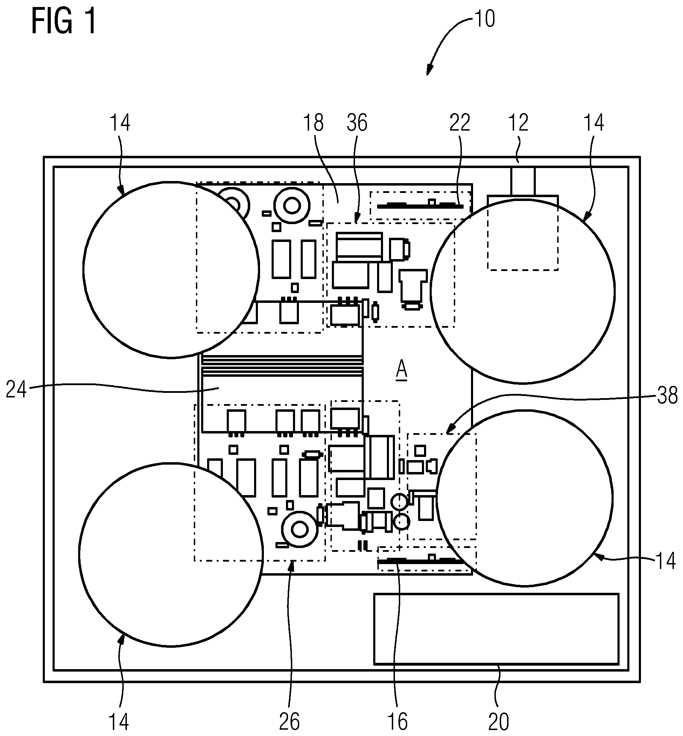

Fig. 1 illustrates an induction cooking hob 10 that comprises a housing 12 which forms an accommodation space for the electric and electronic components of the induction cooking hob 10. The housing 12 with a cooking hob plate usually made of glass ceramics forms an enclosure for the electric and electronic components. In the view of Fig. 1, the cooking hob plate has been removed in order to make the accommodation space and the electric and electronic components housed therein visible.

The electric and/or electronic components comprise four induction coils 14 and a first board element 18 in the form of a printed circuit board. One or more generators 26, components of a power supply 38, mains supply inputs 36 that may comprise electric or electronic filter elements are mounted to the printed circuit board. Further, the first board element 18 comprises a heat sink 24 for cooling the electrical and/or electronic components.

In the specific embodiment shown in Fig. 1, the first board element 18 represents a power board of the induction cooking hob. The power board is a printed circuit board which comprises one or more power generators of the induction cooking hob, wherein one or more power generators are associated to one induction coil in order to power the induction coil to which the one or more power generators are associated.

Further, a second and a third board element 16, 22 are provided in association with the first board element 18. Second and third board element 16, 22 are also provided in the form of a printed circuit board. Each of the board elements 16, 22 may comprise one or more microcontrollers and other circuitry, such as resistors, capacitors etc. and are provided in order to control operation of the induction cooking hob, in particular to control operation of the induction coils and more specifically to control operation of the power board. In particular, the third board element 22 may be coupled electrically and mechanically to the first board element 18 in the same way as the second board element 16, but may have different circuitry.

The housing 12 if the induction cooking hob 10 has supporting means for fixedly supporting the first board element 18 within the accommodation space. Specifically, the first board element 18 is fixedly supported in the accommodation space such that it is arranged in a horizontal position, when the induction cooking hob is installed in a kitchen under normal operating conditions. Accordingly, the second and third board elements 16, 22 are arranged in a vertical position, i.e. orthogonal relative to the first board element 18.

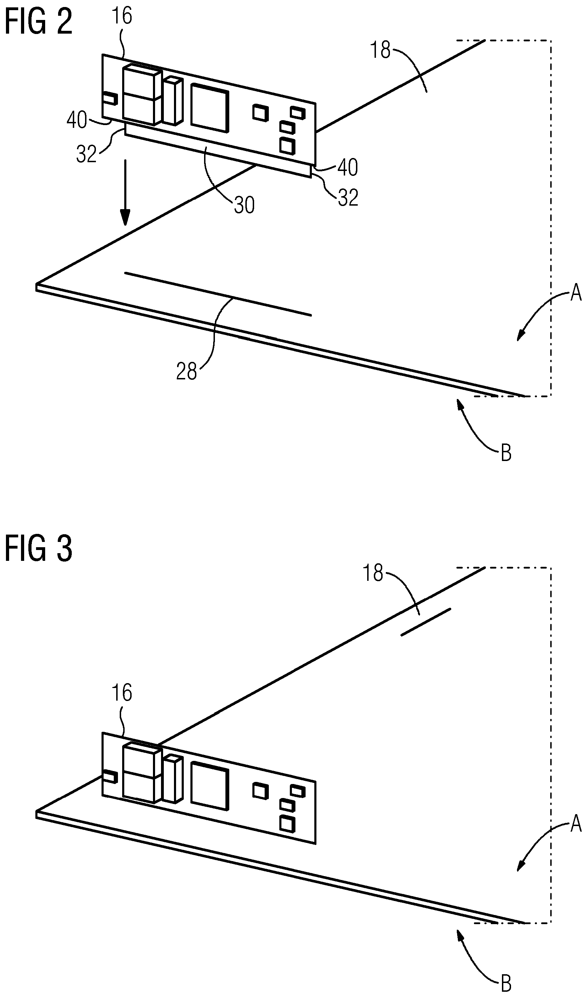

Fig. 2 and Fig. 3 illustrate the arrangement of the first board element 18 and the second board element 16 relative to each other. The first board element 18 comprises a recess 28 in the form of a slit or slot in which the second board element 16 can be inserted. For this purpose, the second board element 16 may have a projecting portion 30 that projects away from a central portion of the second board element 16.

In this specific case, the second board element 16 has a substantially rectangular form, wherein cutouts 32 are provided in two opposing corner regions, such that the projecting portion 30 is formed by the portion of the second board element 16 that is arranged between the cutouts 32. By the way of providing the cutouts 32, the second board element 16 has a bearing surface 40 in the corner regions, where the cutouts 32 are provided, i.e. on bearing surface on side of the second board element 16.

As shown in Fig. 2 and Fig. 3, the second board element 16 is arranged substantially orthogonally relative to the first board element 18. The projecting portion 30 of the second board element 16 and the recess 28 are dimensioned such that the projecting portion 30 can be inserted into the recess 28 of the first board element 18 and can pass through the recess 28 until the bearing surfaces 40 contact the first board element 18 which is the situation seen in Fig. 3.

Subsequent to the insertion of the projecting portion 30 into recess 28, first and the second board elements 18, 16 are connected to each other by a soldering process, in particular by a wave-soldering process.

The soldering process used for connecting the first and second board elements 18, 16 may be the same soldering process used for connecting through hole mounted components to the first board element 18. E.g. it is possible to equip the first board element 18 with through hole mounted components by inserting pins of through hole mounted components into through holes of the first board element 18 and to equip the first board element 18 with the second board element 16 by inserting the projecting portion 30 into the recess 28 in the same manufacturing step. The free end sections of the pins of the through hole mounted components and the projecting portion 30 protrude on the same side, i.e. the lower side of the first board element. Subsequently, the through hole mounted components and the second board element 16 are soldered in the same soldering step to the first board element 18.

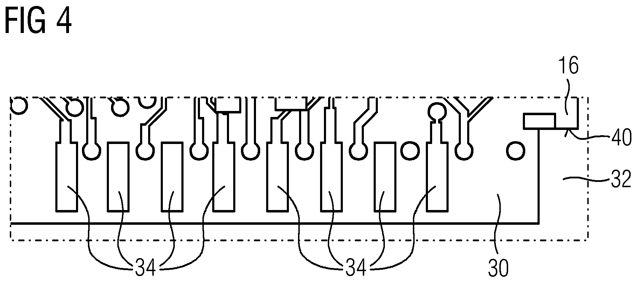

Fig. 4 illustrates the projecting portion 30 in detail. The projecting portion 30 comprises a plurality of conductors 34 being applied as printed circuitry to the second board element 16. Each of the conductors 34 has a broadened end section or so-called solder pad that is provided for being electrically connected by soldering to a corresponding conductor arranged on the first board element 18 and being fixedly assigned to a respective conductor 34 on the second board element 16. The solder pads of the conductors 34 can be electrically connected to their fixedly assigned counterparts of conductors provided on the first board element 18 by the above described soldering process.

The form of the projecting portion 30 and the position of the conductors 34, specifically of their solder pads, on the projecting portion 30 is adapted to the form of the recess 28 and to the position of the corresponding conductors, specifically of the solder pads of the corresponding conductors, on the first board element 18 such that the conductors 34 on the projecting portion 30 and the corresponding conductors on the first board element 18 exactly fit together after insertion of the projecting portion 30 into the recess 28 such that after insertion of the projecting portion 30 into the recess 28, the second board element 16 needs not to be moved further relative to the first board element 18 before the first and second board elements 16, 18 are soldered together.

A specific advantage of the arrangement and connection of the first board element 18 with the second board element 16 is that the SMD (surface mounted device) components can be provided in a surface mounting process on the second board element 16 in a previous manufacturing step, wherein the second board element 16 can be mounted and soldered to the first board element 18 in a subsequent manufacturing step.

### List of reference numerals

- 10: Induction cooking hob
- 12: Housing
- 14: Induction coils
- 16: Second board element
- 18: First board element
- 20: User interface
- 22: Third board element
- 24: Heat sink
- 26: Generator
- 28: Recess
- 30: Projecting portion
- 32: Cutout
- 34: Conductors
- 36: Mains supply inputs
- 38: Power supply
- 40: Bearing surface

- A: Upper side
- B: Lower side

## Claims

1. Induction cooking hob comprising at least one first board element (18) and at least one second board element (16), wherein the first board element (18) and at least one second board element (16) each comprise at least one or more electrical and/or electronical component(s), wherein the first board element(18) is electrically coupled to the second board element (16) and wherein the first board element (18) is directly mechanically coupled to the second board element (16)
wherein the first board element (18) and/or the second board element (16) comprise(s) a substantially flat and/or substantially planar substrate element;
**characterised in that**
the substrate element of the second board element (16) is arranged non-parallel, preferably orthogonal, to the substrate element of the first board element (18);
wherein the substrate element of the second board element (16) extends within, preferably passes through, at least one recess (28) of the substrate element of the first board element (18).

2. Induction cooking hob according to claim 1, **characterized in that** the first board element (18) is a printed circuit board (18) and/or **in that** the second board element (16) is a printed circuit board (16), in particular wherein the first printed circuit board (18) is a power board of the induction cooking hob and/or wherein the second printed circuit board (16) is a control board of the induction cooking hob.

3. Induction cooking hob according to any of the preceding claims, **characterized in that** the first board element (18) comprises a paper based composite epoxy material, in particular including at least one or two layers of woven glass fabric, and the second board element (16) comprises a glass reinforced epoxy laminate material.

4. Induction cooking hob according to any of the preceding claims, **characterized in that** the substrate element of the second board element (16) is directly soldered to the substrate element of the first board element (18), in particular wherein the substrate element of the second board element (16) is additionally attached to the substrate element of the first board element (18) by an adhesive.

5. Induction cooking hob according to any of the preceding claims, **characterized in that** the second board element (16), in particular the substrate element of the second board element (16), comprises a projecting portion (30) which passes through the recess (28) provided in or on, in particular in the substrate element of, the first board element (18).

6. Induction cooking hob according to any of the preceding claims, **characterized in that** the first board element (18) is in direct, in particular touching, contact to the second board element (16), in particular wherein the second board element (16) comprises least one or two or more cutouts (32) that are delimited by one or two or more bearing surfaces (40) provided for bearing on the first board element (18) and/or that are delimited by the projecting portion (30) of the second board element (16).

7. Induction cooking hob according to any of the preceding claims, **characterized in that** the recess (28) is a slot or slit being arranged in the substrate element of the second board element (16), in particular wherein the slot or the slit has a width being substantially identical to the thickness of the substrate element of the first board element (18).

8. Induction cooking hob according to claim 6 or 7, **characterized in that** the recess (28) has a width in a range from 0,8mm to 3,2mm, in particular in a range from 1mm to 2mm, preferably in a range from 1,4mm to 1,8mm,
and/or **characterized in that** the projecting portion (30) protrudes beyond the surface of the substrate element of the second board element (16) in a range from 1mm to 5mm, in particular in a range from 2mm to 4mm, preferably 3mm.

9. Induction cooking hob according to any of the preceding claims, **characterized in that** the projecting portion (30) comprises a plurality of conductors (34), wherein a part of the plurality or all of the conductors (34) are provided for being electrically connected to respective corresponding conductors arranged on the first board element (18), wherein a part of the plurality or all of the conductors (34) are provided for being fixedly assigned to the respective corresponding conductors arranged on the second board element (16).

10. Induction cooking hob according to claim 9, **characterized in that** the form of the projecting portion (30) and/or the position of the conductors (34) on the projecting portion (30) is adapted to the form of the recess (28) and/or to the position of the respective corresponding conductors on the first board element (18) such that the conductors (34) on the projecting portion (30) and the corresponding conductors on the first board element (18) exactly fit together after insertion of the projecting portion (30) into the recess (28), in particular such that the conductors (34) can be electrically and/or mechanically connected to their fixedly assigned counterparts on the first board element (18), preferably by a soldering process, after insertion of the projecting portion (30) into the recess (28).

11. Induction cooking hob according to any of the preceding claims, **characterized in that** the second board element (16) is arranged in a peripheral region of the first board element (18) adjacent to a first peripheral edge and/or adjacent to a second peripheral edge of the first board element (18), in particular such that a longitudinal extension of the second board element (16) is substantially parallel to the first peripheral edge of the first board element (18) and/or such that a longitudinal extension of the second board element (16) is substantially orthogonal to the second peripheral edge of the first board element (18).

12. Induction cooking hob according to any of the preceding claims, **characterized in that** at least one third board element (22) is provided, in particular wherein the third board element (22) is electrically coupled and directly mechanically coupled to the first board element (18) in the same way as the second board element (16), in particular wherein the second board element (16) and the third board element (22) are arranged in different peripheral regions of the first board element (18), preferably that are opposite to each other, in particular wherein the first board element (18) comprises circuitry in the region between second board element (16) and the third board element (22) and wherein the region of the first board element (18) between the second board element (16) and the first peripheral edge does not comprise any circuitry and/or wherein the region of the first board element (18) between the third board element (22) and a peripheral edge adjacent to the third board element (22) does not comprise any circuitry.

13. Induction cooking hob according to any of the preceding claims, **characterized in that** the first board element (18) comprises exclusively through hole mounted electrical and/or electronical components,
and/or **characterized in that** the second board element (16) and/or the third board element (22) comprises exclusively surface mounted device (SMD) electrical and/or electronical components.

14. Method for manufacturing an induction cooking hob according to any one of the preceding claims, **characterized in that** the first board element (18) comprises through hole mounted components, wherein the second board element (16) and the through hole mounted components are soldered to the first board element (18) in one soldering step.

## Patentansprüche

1. Induktionskochfeld umfassend wenigstens ein erstes Platinenelement (18) und wenigstens ein zweites Platinenelement (16),
wobei das erste Platinenelement (18) und wenigstens ein zweites Platinenelement (16) jeweils wenigstens eine oder mehrere elektrische und/oder elektronische Komponenten umfassen, wobei das erste Platinenelement (18) elektrisch an das zweite Platinenelement (16) gekoppelt ist und wobei das erste Platinenelement (18) direkt mechanisch an das zweite Platinenelement (16) gekoppelt ist wobei das erste Platinenelement (18) und/oder das zweite Platinenelement (16) ein im Wesentlichen flaches und/oder im Wesentlichen planares Substratelement umfasst;
**dadurch gekennzeichnet, dass** das Substratelement des zweiten Platinenelements (16) nichtparallel, vorzugsweise orthogonal, zu dem Substratelement des ersten Platinenelements (18) angeordnet ist;
wobei das Substratelement des zweiten Platinenelements (16) innerhalb wenigstens einer Aussparung (28) des Substratelements des ersten Platinenelements (18) verläuft, vorzugsweise hindurchgeht.

2. Induktionskochfeld nach Anspruch 1, **dadurch gekennzeichnet, dass** das erste Platinenelement (18) eine Leiterplatte (18) ist und/oder dass das zweite Platinenelement (16) eine Leiterplatte (16) ist, insbesondere wobei die erste Leiterplatte (18) eine Leistungsplatine des Induktionskochfelds ist und/oder wobei die zweite Leiterplatte (16) eine Steuerplatine des Induktionskochfelds ist.

3. Induktionskochfeld nach einem der vorstehenden Ansprüche, **dadurch gekennzeichnet, dass** das erste Platinenelement (18) ein Verbundepoxidmaterial auf Papierbasis umfasst, insbesondere wenigstens eine oder zwei Schichten aus Glasgewebe umfasst, und das zweite Platinenelement (16) ein glasverstärktes Epoxylaminatmaterial umfasst.

4. Induktionskochfeld nach einem der vorstehenden Ansprüche, **dadurch gekennzeichnet, dass** das Substratelement des zweiten Platinenelements (16) direkt an das Substratelement des ersten Platinenelements (18) gelötet ist, insbesondere wobei das Substratelement des zweiten Platinenelements (16) zusätzlich mit einem Klebstoff an dem Substratelement des ersten Platinenelements (18) befestigt ist.

5. Induktionskochfeld nach einem der vorstehenden Ansprüche, **dadurch gekennzeichnet, dass** das zweite Platinenelement (16), insbesondere das Substratelement des zweiten Platinenelements (16), einen vorstehenden Abschnitt (30) aufweist, der durch die Aussparung (28) verläuft, die die in oder an, insbesondere in, dem Substratelement des ersten Platinenelements (18) bereitgestellt ist.

6. Induktionskochfeld nach einem der vorstehenden Ansprüche, **dadurch gekennzeichnet, dass** das erste Platinenelement (18) in direktem, insbesondere berührendem, Kontakt mit dem zweiten Platinenelement (16) steht, insbesondere wobei das zweite Platinenelement (16) wenigstens eine oder zwei oder mehr Ausschnitte (32) umfasst, die durch eine oder zwei oder mehr Auflageflächen (40) begrenzt sind, die zum Aufliegen auf dem ersten Platinenelement (18) vorgesehen sind und/oder die durch den vorstehenden Abschnitt (30) des zweiten Platinenelements (16) begrenzt sind.

7. Induktionskochfeld nach einem der vorstehenden Ansprüche, **dadurch gekennzeichnet, dass** die Aussparung (28) eine Nut oder oder ein Schlitz ist, die/der in dem Substratelement des zweiten Platinenelements (16) angeordnet ist, insbesondere wobei die Nut oder der Schlitz eine Breite aufweist, die im Wesentlichen gleich der Dicke des Substratelements des ersten Platinenelements (18) ist.

8. Induktionskochfeld nach Anspruch 6 oder 7, **dadurch gekennzeichnet, dass** die Aussparung (28) eine Breite in einem Bereich von 0,8 mm bis 3,2 mm, insbesondere in einem Bereich von 1 mm bis 2 mm, vorzugsweise in einem Bereich von 1,4 mm bis 1,8 mm, aufweist.
und/oder **dadurch gekennzeichnet, dass** der vorstehende Abschnitt (30) in einem Bereich von 1 mm bis 5 mm, insbesondere in einem Bereich von 2 mm bis 4 mm, vorzugsweise 3 mm, über die Oberfläche des Substratelements des zweiten Platinenelements (16) vorsteht.

9. Induktionskochfeld nach einem der vorstehenden Ansprüche, **dadurch gekennzeichnet, dass** der vorstehende Abschnitt (30) eine Vielzahl von Leitern (34) umfasst, wobei ein Teil der Vielzahl von oder alle der Leiter (34) dafür vorgesehen sind, elektrisch mit entsprechenden Leitern verbunden zu werden, die an dem ersten Platinenelement (18) angeordnet sind, wobei ein Teil der Vielzahl von oder alle der Leiter (34) dafür vorgesehen ist, den jeweiligen entsprechenden Leitern, die an dem zweiten Platinenelement (16) angeordnet sind, fest zugeordnet zu werden.

10. Induktionskochfeld nach Anspruch 9, **dadurch gekennzeichnet, dass** die Form des vorstehenden Abschnitts (30) und/oder die Position der Leiter (34) auf dem vorstehenden Abschnitt (30) an die Form der Aussparung (28) und/oder an die Position der jeweiligen entsprechenden Leiter an dem ersten Platinenelement (18) angepasst ist, so dass die Leiter (34) an dem vorstehenden Abschnitt (30) und die entsprechenden Leiter an dem ersten Platinenelement (18) nach dem Einsetzen des vorstehenden Abschnitts (30) in die Aussparung (28) genau zusammenpassen, insbesondere derart, dass die Leiter (34) nach dem Einsetzen des vorstehende Abschnitts (30) in die Aussparung (28) mit ihren fest zugeordneten Gegenstücken an dem ersten Platinenelement (18) elektrisch und/oder mechanisch, vorzugsweise durch ein Lötverfahren, verbunden werden können.

11. Induktionskochfeld nach einem der vorstehenden Ansprüche, **dadurch gekennzeichnet, dass** das zweite Platinenelement (16) in einem Randbereich des ersten Platinenelements (18) benachbart zu einem ersten Umfangsrand und/oder benachbart zu einem zweiten Umfangsrand des ersten Platinenelements (18) angeordnet ist, insbesondere derart, dass eine Längserstreckung des zweiten Platinenelements (16) im Wesentlichen parallel zu dem ersten Umfangsrand des ersten Platinenelements (18) ist, und/oder derart, dass eine Längserstreckung des zweiten Platinenelements (16) im Wesentlichen senkrecht zu dem zweiten Umfangsrand des ersten Platinenelements (18) ist.

12. Induktionskochfeld nach einem der vorstehenden Ansprüche, **dadurch gekennzeichnet, dass** wenigstens ein drittes Platinenelement (22) bereitgestellt ist, insbesondere wobei das dritte Platinenelement (22) in gleicher Weise wie das zweite Platinenelement (16) an das erste Platinenelement (18) elektrisch gekoppelt und direkt mechanisch gekoppelt ist, insbesondere wobei das zweite Platinenelement (16) und das dritte Platinenelement (22) in unterschiedlichen Umfangsbereichen des ersten Platinenelements (18) angeordnet sind, die einander vorzugsweise gegenüberliegen, insbesondere wobei das erste Platinenelement (18) eine Schaltungsanordnung in dem Bereich zwischen dem zweiten Platinenelement (16) und dem dritten Platinenelement (22) umfasst und wobei der Bereich des ersten Platinenelements (18) zwischen dem zweiten Platinenelement (16) und dem ersten Umfangsrand keine Schaltungsanordnung umfasst und/oder wobei der Bereich des ersten Platinenelements (18) zwischen dem dritten Platinenelement (22) und einem Umfangsrand, der an das dritte Platinenelement (22) angrenzt, keine Schaltungsanordnung umfasst.

13. Induktionskochfeld nach einem der vorstehenden Ansprüche, **dadurch gekennzeichnet, dass** das erste Platinenelement (18) ausschließlich durchsteckmontierte elektrische und/oder elektronische Komponenten umfasst, und/oder **dadurch gekennzeichnet, dass** das zweite Platinenelement (16) und/oder das dritte Platinenelement (22) ausschließlich oberflächenmontierte elektrische und/oder elektronische Bauelemente (SMD) umfasst.

14. Verfahren zur Herstellung eines Induktionskochfelds nach einem der vorstehenden Ansprüche, **dadurch gekennzeichnet, dass** das erste Platinenelement (18) durchsteckmontierte Komponenten umfasst, wobei das zweite Platinenelement (16) und die durchsteckmontierten Komponenten in einem Lötschritt an das erste Platinenelement (18) gelötet werden.

## Revendications

1. Table de cuisson par induction comprenant au moins un premier élément carte (18) et au moins un deuxième élément carte (16),
le premier élément carte (18) et au moins un deuxième élément carte (16) comprenant chacun au moins un ou plusieurs composants électriques et/ou électroniques, le premier élément carte (18) étant électriquement couplé au deuxième élément carte (16) et le premier élément carte (18) étant mécaniquement couplé directement au deuxième élément carte (16)
le premier élément carte (18) et/ou le deuxième élément carte (16) comprenant un élément substrat sensiblement plat et/ou sensiblement plan ;
**caractérisée en ce que** l'élément substrat du deuxième élément carte (16) est disposé de manière non parallèle, de préférence orthogonale, à l'élément substrat du premier élément carte (18) ;
l'élément substrat du deuxième élément carte (16) s'étendant à l'intérieur, de préférence traversant, au moins un évidement (28) de l'élément substrat du premier élément carte (18).

2. Table de cuisson par induction selon la revendication 1, **caractérisée en ce que** le premier élément carte (18) est une carte de circuit imprimé (18) et/ou **en ce que** le deuxième élément carte (16) est une carte de circuit imprimé (16), en particulier la première carte de circuit imprimé (18) étant une carte d'alimentation de la table de cuisson par induction et/ou la seconde carte de circuit imprimé (16) étant une carte de commande de la table de cuisson par induction.

3. Table de cuisson par induction selon l'une quelconque des revendications précédentes, **caractérisée en ce que** le premier élément carte (18) comprend un matériau époxy composite à base de papier, en particulier comprenant au moins une ou deux couches de tissu de verre tissé, et le deuxième élément carte (16) comprend un matériau stratifié époxy renforcé de verre.

4. Table de cuisson par induction selon l'une quelconque des revendications précédentes, **caractérisée en ce que** l'élément substrat du deuxième élément carte (16) est soudé directement à l'élément substrat du premier élément carte (18), en particulier l'élément substrat du deuxième élément carte (16) étant fixé en plus à l'élément substrat du premier élément carte (18) par un adhésif.

5. Table de cuisson par induction selon l'une quelconque des revendications précédentes, **caractérisée en ce que** le deuxième élément carte (16), en particulier l'élément substrat du deuxième élément carte (16), présente une partie saillante (30) qui traverse l'évidement (28) ménagé dans ou sur le premier élément carte (18), en particulier dans l'élément substrat de celui-ci.

6. Table de cuisson par induction selon l'une quelconque des revendications précédentes, **caractérisée en ce que** le premier élément carte (18) est en contact direct, en particulier par contact, avec le deuxième élément carte (16), en particulier, le deuxième élément carte (16) comprend au moins une ou deux découpes (32) qui sont délimitées par une ou deux ou plusieurs surfaces d'appui (40) prévues pour s'appuyer sur le premier élément carte (18) et/ou qui sont délimitées par la partie saillante (30) du deuxième élément carte (16).

7. Table de cuisson par induction selon l'une quelconque des revendications précédentes, **caractérisée en ce que** l'évidement (28) est une fente ou une entaille ménagée dans l'élément substrat du deuxième élément carte (16), en particulier la fente ou l'entaille ayant une largeur sensiblement identique à l'épaisseur de l'élément substrat du premier élément carte (18).

8. Table de cuisson par induction selon la revendication 6 ou 7, **caractérisée en ce que** l'évidement (28) a une largeur dans une plage comprise entre 0,8 mm et 3,2 mm, en particulier dans une plage comprise entre 1 mm et 2 mm, de préférence dans une plage comprise entre 1,4 mm et 1,8 mm.
et/ou **caractérisée en ce que** la partie saillante (30) fait saillie au-delà de la surface de l'élément substrat du deuxième élément carte (16) dans une plage comprise entre 1 mm et 5 mm, en particulier dans une plage comprise entre 2 mm et 4 mm, de préférence de 3 mm.

9. Table de cuisson par induction selon l'une quelconque des revendications précédentes, **caractérisée en ce que** la partie saillante (30) comprend une pluralité de conducteurs (34), une partie de la pluralité ou la totalité des conducteurs (34) étant fournis pour être connectés électriquement à des conducteurs correspondants respectifs disposés sur le premier élément carte (18), une partie de la pluralité ou la totalité des conducteurs (34) étant fournis pour être associés de manière fixe aux conducteurs correspondants respectifs disposés sur le deuxième élément carte (16).

10. Table de cuisson par induction selon la revendication 9, **caractérisée en ce que** la forme de la partie saillante (30) et/ou la position des conducteurs (34) sur la partie saillante (30) est adaptée à la forme de l'évidement (28) et/ou à la position des conducteurs correspondants respectifs sur le premier élément carte (18), de sorte que les conducteurs (34) sur la partie saillante (30) et les conducteurs correspondants sur le premier élément carte (18) correspondent exactement après insertion de la partie saillante (30) dans l'évidement (28), en particulier de sorte que les conducteurs (34) puissent être reliés électriquement et/ou mécaniquement à leurs homologues associés de manière fixe sur le premier élément carte (18), de préférence par un processus de soudage, après insertion de la partie saillante (30) dans l'évidement (28).

11. Table de cuisson par induction selon l'une quelconque des revendications précédentes, **caractérisée en ce que** le deuxième élément carte (16) est disposé dans une zone périphérique du premier élément carte (18) adjacente à un premier bord périphérique et/ou adjacente à un second bord périphérique du premier élément carte (18), en particulier de sorte qu'une extension longitudinale du deuxième élément carte (16) soit sensiblement parallèle au premier bord périphérique du premier élément carte (18) et/ou de sorte qu'une extension longitudinale du deuxième élément carte (16) soit sensiblement orthogonale au second bord périphérique du premier élément carte (18).

12. Table de cuisson par induction selon l'une quelconque des revendications précédentes, **caractérisée en ce qu'**au moins un troisième élément carte (22) est fourni, en particulier le troisième élément carte (22) étant électriquement couplé et mécaniquement couplé directement au premier élément carte (18) de la même manière que le deuxième élément carte (16), en particulier le deuxième élément carte (16) et le troisième élément carte (22) étant disposés dans des zones périphériques différentes du premier élément carte (18), de préférence, qui sont opposées l'une à l'autre, en particulier, le premier élément carte (18) comprenant des circuits dans la région entre le deuxième élément carte (16) et le troisième élément carte (22) et la région du premier élément carte (18) entre le deuxième élément carte (16) et le premier bord périphérique ne comprenant pas de circuits et/ou la région du premier élément carte (18) entre le troisième élément carte (22) et un bord périphérique adjacent au troisième élément carte (22) ne comprenant pas de circuits.

13. Table de cuisson par induction selon l'une quelconque des revendications précédentes, **caractérisée en ce que** le premier élément carte (18) comprend exclusivement des composants électriques et/ou électroniques montés dans des trous traversants,
et/ou **caractérisée en ce que** le deuxième élément carte (16) et/ou le troisième élément carte (22) comprend exclusivement des composants électriques et/ou électroniques montés en surface (SMD).

14. Procédé de fabrication d'une table de cuisson par induction selon l'une quelconque des revendications précédentes, **caractérisé en ce que** le premier élément carte (18) comprend des composants montés dans des trous traversants, le deuxième élément carte (16) et les composants montés dans des trous traversants étant soudés au premier élément carte (18) en une étape de soudage.
